# EUROPEAN PATENT APPLICATION

(11) **EP 2 216 277 A1**
(43) Date of publication of application: **11.08.2010**
(21) Application number: 08836514.3
(22) Date of filing: 29.09.2008
(51) Int. Cl.: B65G 49/06, H01L 21/677

(54) **SUBSTRATE HOLDING MECHANISM, SUBSTRATE DELIVERY/RECEPTION MECHANISM, AND SUBSTRATE PROCESSING DEVICE**

(30) Priority: 05.10.2007 JP 2007262545
(71) Applicant: Evatech Co., Ltd., Kuze-gun Kyoto 613-0024 (JP)
(72) Inventor: ISHIHARA, Shinichiro, Kuze-gun Kyoto 613-0024 (JP); ASHIDA, Hajime, Kuze-gun Kyoto 613-0024 (JP); WATANABE, Akira, Kuze-gun Kyoto 613-0024 (JP)
(74) Representative: Hehl, Ulrich
(86) International application number: PCT/JP2008/002707
(87) International publication number: WO 2009/044526

(57) **Abstract**

The present invention provides a substrate holding mechanism capable of assuredly holding a substrate and delivering/receiving it: a substrate holding mechanism including a substrate holding unit for holding a rectangular substrate W, comprising: a plurality of substrate holding rollers 120 provided at positions corresponding to two opposite sides of the substrate W on the substrate holding unit and pivotally supported by the substrate holding unit; and a roller driver for rotating the substrate holding rollers 120, wherein: the substrate holding roller 120 comprises a cylinder part 121 and a holding flange 123a or 123b provided along a portion of a circumference of each end of the cylinder part 121; and each of the substrate holding rollers 120 is rotated by the roller driver so that a state of holding edges of the substrate W by the holding flange 123a or 123b and a state of releasing the edges can be switched in accordance with a rotation angle of the substrate holding rollers 120.

## Description

### SUBSTRATE HOLDING MECHANISM, SUBSTRATE DELIVERING/RECEIVING MECHANISM, AND SUBSTRATE PROCESSING APPARATUS

### TECHNICAL FIELD

The present invention relates to a substrate holding mechanism for holding a rectangular substrate such as a glass substrate. The present invention also relates to a substrate delivering/receiving mechanism and a substrate processing apparatus including the substrate holding mechanism.

### BACKGROUND ART

In the process of manufacturing semiconductors, liquid crystals, thin-film photovoltaic cells, or other products, a substrate processing apparatus is used to perform one or more processes of a chemical vapor deposition (CVD) process, sputtering process, dry-etching process, and other processes on a substrate. Such a substrate processing apparatus generally includes a substrate carrying mechanism for carrying a substrate into each of the processing chambers and taking it out from the chamber in the apparatus. In conventional types of substrate carrying mechanism a so-called carrier method is widely used, in which a substrate is set on a tray-shaped carrier and the substrate is carried together with the carrier. These days, however, a carrierless system is becoming the mainstream for a substrate carrying mechanism. In order to enhance the processing efficiency and prevent the attachment of particles to a substrate, this system uses a carrying mechanism having an arm or arms with which the substrate can directly held at its edge portion and singly carried into a processing chamber.

With the recent growth in screen size of flat-panel displays and the growth in the area of photovoltaic cells, the size of a glass substrate, which is a main element of them, is becoming larger. Since a substrate is generally carried in a horizontal position in the conventional substrate processing apparatuses, the growth in size of a substrate causes problems: For example, a substrate is bent by its own weight to be damaged and a larger area is required to install the substrate processing apparatus.

To solve such problems, recently, substrate processing apparatuses in which a substrate is carried and processed in a vertical position have been devised. For example, Patent Document 1 discloses a substrate carrying apparatus including: a carrierless substrate carriage for carrying a substrate in an oblique position; and a rising-up substrate delivering/receiving mechanism for standing the substrate from the horizontal position and delivering the substrate to the substrate carriage. The rising-up substrate delivering/receiving mechanism is built among substrate carrying rollers for carrying the substrate to a substrate delivering/receiving stage. The roller frame at the position of the substrate delivering/receiving stage stands to a secure tilt angle separately from other substrate carrying roller units, and moves closer to a substrate holding mechanism on the substrate carriage to deliver the substrate. The rising-up substrate delivering/receiving mechanism includes a substrate holding hook for holding the lower edge of the substrate which is held by the roller frame when the roller frame stands at the secure tilt angle. It is also disclosed that the substrate carriage includes a gripping hook for touching and gripping the substrate on the roller frame when the substrate holding mechanism on the carriage and the roller frame in the standing position approach each other.

[Patent Document 1] Japanese Unexamined Patent Application Publication No. 2002-167036 ([0008], [0022], and Fig. 2)

### DISCLOSURE OF THE INVENTION

### PROBLEM TO BE SOLVED BY THE INVENTION

In the apparatus disclosed in Patent Document 1, a substrate is delivered and received while the substrate is obliquely propped against the roller frame in the standing position and the lower edge is placed on the substrate holding hook which is provided in the lower part of the roller frame. Accordingly, the position of the substrate might become unstable when the roller frame is made to stand up, which leads to an uncertain delivery of the substrate to the substrate carriage.

Given this factor, the problem to be solved by the present invention is to provide a substrate holding mechanism capable of assuredly holding and delivering/receiving a substrate, and provide a substrate delivering/receiving mechanism and a substrate processing apparatus including the substrate holding mechanism.

### MEANS FOR SOLVING THE PROBLEM

To solve the previously described problems, the first aspect of the present invention provides a substrate holding mechanism including a substrate holding unit for holding a rectangular substrate, including:
a) a plurality of substrate holding rollers provided at positions corresponding to two opposite sides of the substrate on the substrate holding unit and rotatably supported by the substrate holding unit; and
b) a roller driver for rotating the substrate holding rollers, wherein:
   the substrate holding roller includes a cylinder part and a holding flange provided along a portion of a circumference of each end of the cylinder part; and
      each of the substrate holding rollers is rotated by the roller driver so that the holding flange can be switched between a state of holding edges of the substrate and a state of releasing the substrate in accordance with a rotation angle of the substrate holding rollers.

The second aspect of the present invention provides a substrate delivering/receiving mechanism including a first substrate holding means and a second substrate holding means, each including the substrate holding mechanism according to the first aspect of the present invention, wherein:
the substrate holding rollers of the first substrate holding means and the substrate holding rollers of the second substrate holding means are placed at a position where the substrate holding rollers are free from obstructing each other when the substrate holding units of both substrate holding means are made to face each other; and
the first substrate holding means holding a substrate and the second substrate holding means without a substrate are moved closer to each other with the substrate holding units of both substrate holding means opposing each other, then the substrate holding rollers on the second substrate holding means are rotated to hold the edges of the substrate by each of the holding flanges and the substrate holding rollers on the first substrate holding means are rotated to release the edges of the substrate by each of the holding flanges, so that the substrate is delivered from the first substrate holding means to the second substrate holding means.

### EFFECTS OF THE INVENTION

With the substrate holding mechanism having the configuration of the first aspect of the present invention, a substrate can be assuredly held or released from the held state by rotating the substrate holding rollers at a predetermined angle by the roller driver.

With the substrate delivering/receiving mechanism having the configuration of the second aspect of the present invention, a substrate can be assuredly delivered and received between the first substrate holding means and the second substrate holding means by the following manner: approximating the substrate holding unit of the first substrate holding means and the substrate holding unit of the second substrate holding means; and holding the substrate by the second substrate holding means and releasing it from the first substrate holding means by rotating their substrate holding rollers.

In the substrate delivering/receiving mechanism according to the second aspect of the present invention, preferably, the first substrate holding means is a substrate standing mechanism for holding a substrate carried in a horizontal position and for standing the substrate to a vertical position;
the second substrate holding means is a both-side type substrate holding means including the substrate holding unit on each of a front side and a back side; and
two substrates are first set from a horizontal position to a vertical position by the two first substrate holding means placed to sandwich the second substrate holding means, and the substrates are delivered to each of the substrate holding units of the second substrate holding means.

With such a configuration, two substrates can be simultaneously delivered to improve the operating efficiency. In addition, the substrates are set vertically to the ground and then delivered to the second substrate holding means, which can prevent particles and otherwise from falling onto the substrate to contaminate it and can reduce the installation area of the apparatus as compared to the case where the substrate is handled in an oblique position.

### BRIEF DESCRIPTION OF THE DRAWINGS

Fig. 1 is a schematic configuration diagram of a substrate processing apparatus according to an embodiment of the present invention.
Fig. 2(a) is a top view of the configuration of a roller conveyer in the substrate processing apparatus of the same embodiment, and Fig. 2(b) is a front view of the same.
Fig. 3(a) is a front view of a substrate holding roller in the substrate holding state, and Fig. 3(b) is a side view of the same.
Fig. 4(a) is a front view of a substrate holding roller in the holding release state, and Fig. 4(b) is a side view of the same.
Fig. 5(a) is a front view of the configuration of an atmosphere-side substrate carrying mechanism in the substrate processing apparatus of the same embodiment, and Fig. 5(b) is a top view of the same.
Fig. 6 is a top view illustrating a state in which a substrate has arrived at the substrate delivering/receiving position in a load section.
Fig. 7 is a front view of the state of Fig. 6.
Fig. 8 is a front view illustrating a state in which roller conveyers are vertically set.
Fig. 9 is a sectional view at line A-A' of Fig. 8.
Fig. 10 is a front view illustrating a state in which the roller conveyers are laid down after substrates have been delivered.
Fig. 11 is a sectional view at line A-A' of Fig. 1.
Fig. 12 is a diagram illustrating a state in which carrying arms have entered a processing chamber.
Fig. 13 is a sectional view at line A-A' of Fig. 12.

### EXPLANATION OF NUMERALS

- 100 ...: Load Section
- 110 ...: Roller Conveyer
- 111 ...: Frame
- 120, 140, 280, 290 ...: Substrate Holding Roller
- 121 ...: Rotation Shaft
- 122 ...: cylinder Part
- 123a, 123b: ... Holding Flange
- 124 ...: Roller Driver
- 130 ...: Atmosphere-Side Substrate Carrying Mechanism
- 131a,: 131b, 271a, 271b ... Carrying Arm
- 200 ...: Processing Unit
- 210, 260 ...: Load Lock Chamber
- 220 ...: Common Carrying Delivery Chamber
- 230 ...: Preheating Chamber
- 240 ...: Processing Chamber
- 242 ...: Heater Plate
- 250 ...: Cooling Chamber
- 270 ...: Vacuum-Side Substrate Carrying Mechanism
- 300 ...: Unload Section
- 400 ...: Drive/Control Unit
- W ...: Substrate

### BEST MODE FOR CARRYING OUT THE INVENTION

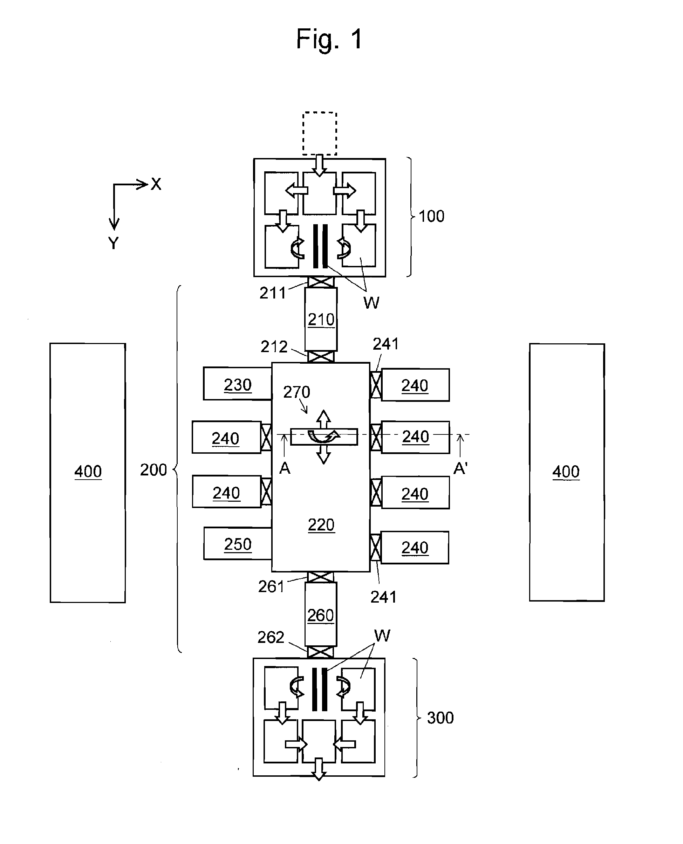

Hereinafter, an embodiment of a substrate processing apparatus having a substrate holding mechanism and a substrate delivering/receiving mechanism according to the present invention will be described with reference to the attached figures. Fig. 1 is a schematic configuration diagram of the substrate processing apparatus according to the present embodiment.

The substrate processing apparatus according to the present invention is a plasma enhanced chemical vapor deposition (PE-CVD) apparatus for forming a thin film on a substrate by the PE-CVD technique. This apparatus is broadly composed of: a drive/control unit 400; a load section 100; an unload section 300; and a processing unit 200.

The processing unit 200 is composed of: a plurality of processing chambers 240 for forming different thin film in each chamber; a preheating chamber 230 for preheating a substrate W before processing; a cooling chamber 250 for cooling the substrate W after processing; load lock chambers 210 and 260 for taking the substrate into the processing unit 200 and taking it out therefrom; and a common carrying delivery chamber 220 having a vacuum-side substrate carrying mechanism 270 for carrying the glass substrate W into these chambers. Gate valves 211, 212, 241, 261, and 262 which can be independently opened and closed are provided at the boundary portion between the load lock chamber 210 and the outside of the processing unit 200, between the common carrying delivery chamber 220 and the load lock chamber 210, between the common carrying delivery chamber 220 and each of the processing chambers 240, between the common carrying delivery chamber 220 and the load lock chamber 260, and between the load lock chamber 260 and the outside of the processing unit 200. Each of the processing chambers 240 and the common carrying delivery chamber 220 are maintained in vacuum by a vacuum pump provided in the drive/control unit 400. The load lock chambers 210 and 260 are pre-vacuum chambers for temporarily holding the substrate W carried from the load section 100 and the substrate W to be carried to the unload section 300, respectively. The load lock chambers 210 and 260 can be evacuated by the vacuum pump when needed.

The load section 100 has: roller conveyers for carrying a substrate W in a horizontal position; and an atmosphere-side substrate carrying mechanism 130 for simultaneously carrying two substrates W in a vertical position into the load lock chamber 210. Substrates W to be processed carried to the load section 100 in a horizontal position are directed alternately leftward and rightward (in the X-axis direction in Fig. 1) by a substrate directing mechanism (not shown), and are carried by the roller conveyers to substrate delivering/receiving positions at right and left sides across the atmosphere-side substrate carrying mechanism 130. The unload section 300 has an atmosphere-side substrate carrying mechanism for simultaneously taking out two processed substrates W in a vertical position from the load lock chamber 260. The substrates W taken out from the load lock chamber 260 are delivered to roller conveyers at substrate delivering/receiving positions located at right and left sides across the atmosphere-side substrate carrying mechanism, to be carried to a subsequent apparatus.

In the drive/control unit 400, a vacuum pump for evacuating each chamber of the processing unit 200, and a control unit for controlling each operation of the aforementioned components are provided.

Hereinafter, a process of delivering/receiving a substrate W in the load section 100 will be described.

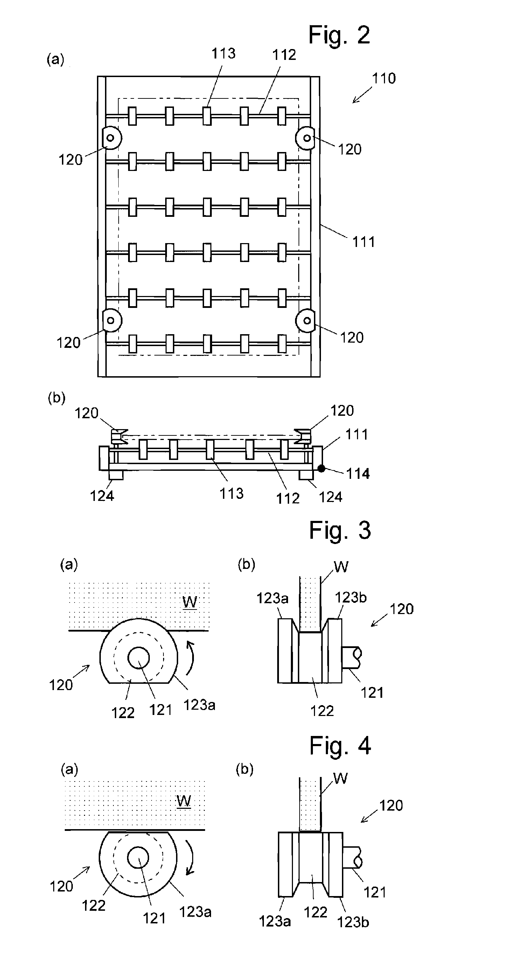

The roller conveyers provided in the load section 100 is for carrying a glass substrate W in a horizontal position to the substrate delivering/receiving positions. The roller conveyers 110 at the substrate delivering/receiving positions are particularly different from other roller conveyers in other positions, and can stand vertically to the ground by being rotated around a rotation axis 114 by a provided driving mechanism (not shown). Fig. 2 illustrates the configuration of the roller conveyer 110. The roller conveyer 110 has a frame 111 and a plurality of shafts 112 whose both ends are rotatably supported by the frame 111. A plurality of sleeves 113 are attached to each of the shafts 112. By rotating each shaft 112 by a provided driving means (not shown), a substrate W lying on the sleeves 113 can be carried in a specific direction.

In the frame 111, substrate holding rollers 120 as illustrated in Figs. 3 and 4 are attached at positions corresponding to the right and left sides of the substrate W (i.e. the upper and lower sides when the substrate W is in an upright position). The substrate holding roller 120 has: a cylinder part 122 with an integrally formed rotation shaft 121; and holding flanges 123a and 123b provided along a portion of the circumference of each of the both ends of the cylinder part 122. Each rotation shaft 121 of the rollers 120 is connected through the frame 111 to a roller driver 124, which is provided on the frame 111. Each substrate holding roller 120 is rotated by these roller drivers 124, and in accordance with the rotation angle, the substrate W can be held (Fig. 3) or released (Fig. 4). Hereinafter, the state of Fig. 3 will be referred to as "substrate holding state," and the state of Fig. 4, as "holding release state." In the substrate holding state, since the edges of the substrate W lie between both the holding flanges 123a and 123b as illustrated in Fig. 3(b), the movement of the substrate W in its thickness direction is restricted.

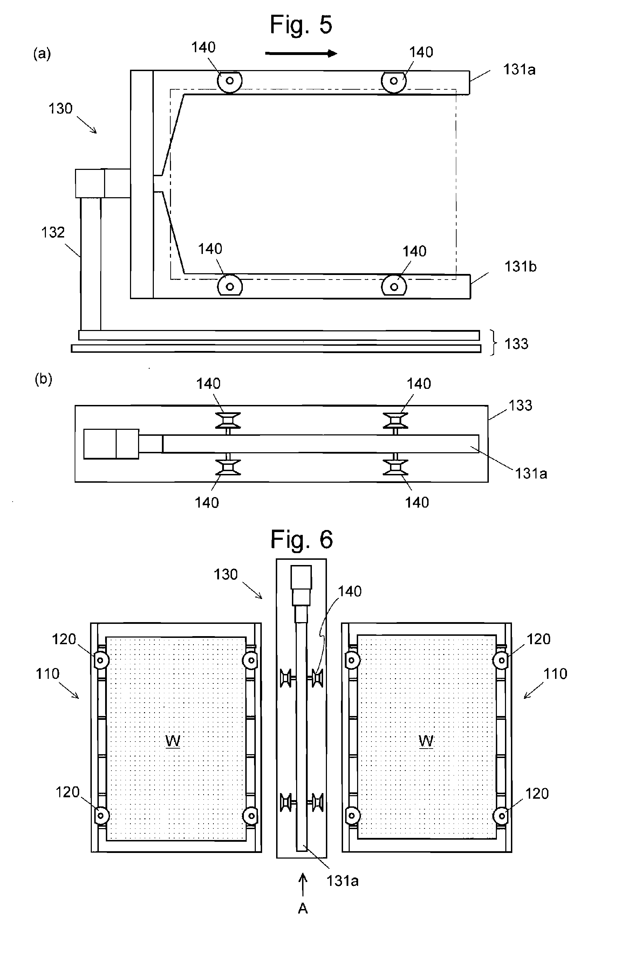

The atmosphere-side substrate carrying mechanism 130 provided in the load section 100 can hold two glass substrate W parallel to each other and vertically to the ground, and has: a sliding base 133 placed in front of the atmosphere-side gate valve 211 of the load lock chamber 210; and a pair of upper and lower carrying arms 131a and 131b provided over the sliding base 133 (Fig. 5). The carrying arms 131a and 131b are fixed to the sliding base 133 by means of a column 132. By driving the sliding base 133 by a driving means which is not shown, the carrying arms 131a and 131b are moved in their extending direction (i.e. in the direction of the arrow of Fig. 5) to enter the load lock chamber 210 via the gate valve in an open state.

On both the front and back sides of each of the carrying arms 131a and 131b, a plurality of substrate holding rollers 140 for holding the upper and lower sides of the substrate W are pivotally supported. Each of the substrate holding rollers 140 is configured as illustrated in Figs. 3 and 4. By rotating each of the substrate holding rollers 140 by a roller driver (not shown) provided on each of the carrying arms 131a and 131b, each roller 140 is set to be either in the substrate holding state or in the holding release state.

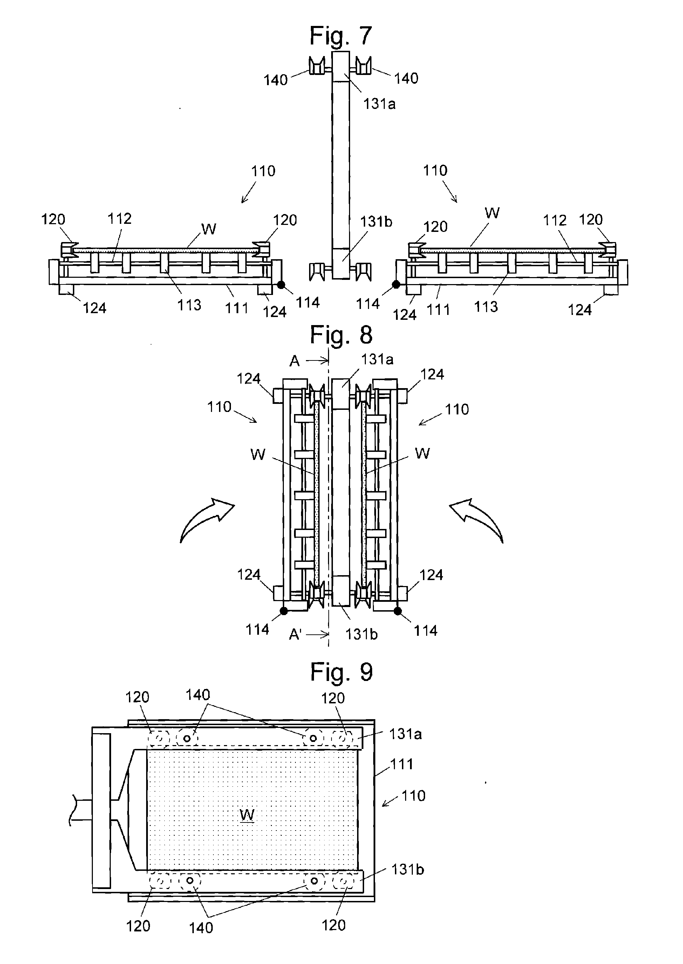

Hereinafter, a procedure of delivering/receiving a substrate W from the roller conveyer 110 to the atmosphere-side substrate carrying mechanism 130 will be described. First, two glass substrates W to be processed are carried to both sides of the substrate delivering/receiving mechanism by the roller conveyers. After both glass substrates W arrive at the substrate delivering/receiving positions, the substrate holding rollers 120 provided in the roller conveyer 110 at the substrate delivering/receiving position rotate to be in the substrate holding state. At this point in time, each of the substrate holding rollers 140 provided in the carrying arms 131a and 131b in the atmosphere-side substrate carrying mechanism 130 is in the holding release state. Fig. 6 is a top view illustrating the roller conveyer 110 and the atmosphere-side substrate carrying mechanism 130 at this point. Fig. 7 is a diagram of the same viewed from the arrow A in Fig. 6.

Subsequently, as illustrated in Fig. 8, each roller conveyer 110 rotates around the rotation axis 114 to stand vertically to the ground, so that the substrates W mounted on each of the conveyers face the front or back side of the carrying arms 131a and 131b. Since the upper and lower sides of the substrates W are held by each of the substrate holding rollers 120 on the roller conveyers 110, the substrates W do not drop from the roller conveyers 110 after the roller conveyers are set upright. At this point in time, the substrate holding rollers 140 on the carrying arms 131a and 131b are in the holding release state. Also, the substrate holding rollers 120 on the roller conveyers 120 and the substrate holding rollers 140 on the carrying arm 131a and 131b are provided in the position where they do not obstruct each other as illustrated in Fig. 9 (which is a sectional view at line A-A' of Fig. 8). Accordingly, each substrate W can be moved closer to the carrying arms 131a and 131b, without a contact between the substrate holding rollers 120 on the roller conveyers 110 and the substrate holding rollers 140 on the carrying arms 131a and 131b as well as a contact between the substrate holding rollers 120 on the carrying arms 131a and 131b and the substrates W.

After that, the substrate holding rollers 140 on the carrying arms 131a and 131b rotate to be in the substrate holding state, and then the substrate holding rollers 120 on the roller conveyers 110 rotate to be in the holding release state. Consequently, each of the substrates W is transshipped from the substrate holding rollers 120 on the roller conveyers 110 to the substrate holding rollers 140 on the carrying arms 131a and 131b.

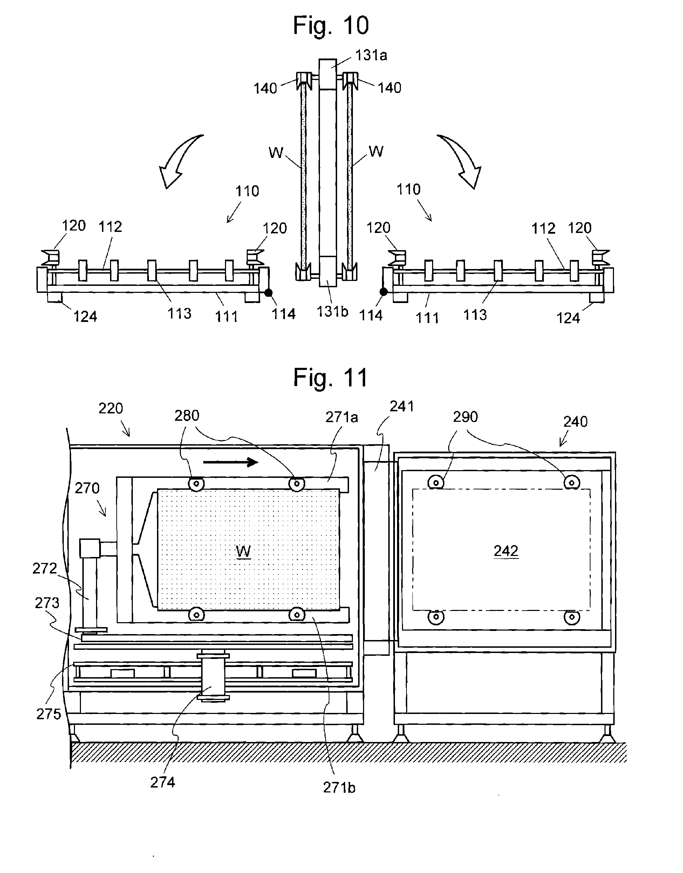

After the substrates W have been delivered/received by the aforementioned process, each of the roller conveyers 110 are returned to their horizontal position (Fig. 10), and the substrates W mounted on the carrying arms 131a and 131b are carried into the load lock chamber 210 by the atmosphere-side substrate carrying mechanism 130.

Such an atmosphere-side substrate carrying mechanism and roller conveyers as described above are also provided in the unload section 300. Two substrates W in a vertical position taken out from the load lock chamber 260 by the atmosphere-side substrate carrying mechanism are, following the procedure opposite to the aforementioned one, delivered from the carrying arms to the roller conveyers, set to the horizontal position, and then carried out to the subsequent process.

Next, a process of delivering/receiving of a substrate W in each processing chamber 240 will be described.

Fig. 11 is a sectional view at line A-A' of Fig. 1. Fig. 11 illustrates a processing chamber 240, a common carrying delivery chamber 220, and a vacuum-side substrate carrying mechanism 270 provided in the common carrying delivery chamber 220, according to the substrate processing apparatus of the present embodiment.

The vacuum-side substrate carrying mechanism 270 is, similar to the previously described atmosphere-side substrate carrying mechanism 130, for carrying two glass substrates W being parallel to each other and vertically to the ground. The vacuum-side substrate carrying mechanism 270 has: a pair of upper and lower carrying arms 271a and 271b; a sliding base 273; a traveling base 275; and a pivot shaft 274. On both front and back sides of each of the carrying arms 271a and 271b, a plurality of substrate holding rollers 280 for holding the upper side or lower side of the substrate W are provided with a predetermined spacing. These substrate holding rollers 280 have the same configuration as illustrated in Figs. 3 and 4. By rotating each of the rollers 280 by roller drivers (not shown) provided on the carrying arms 271a and 271b, the substrate W can be held or released. The carrying arms 271a and 271b are fixed to the sliding base 273 by a column 272. By driving the sliding base 273 by a driving means which is not shown, the carrying arms 271a and 271b can be moved in their extending direction (i.e. in the direction of the arrow of Fig. 11). The sliding base 273 is pivotally fixed to the traveling base 275 through the pivot shaft 274, and the traveling base 275 is placed on a rail laid in the common carrying delivery chamber 220. By driving these traveling base 275 and pivot shaft 274 by a driving means which is not shown, the carrying arms 271a and 271b can be rotated around the pivot shaft 274 as well as can be moved in the direction perpendicular to the moving direction of the sliding base 273.

In the processing chamber 240, two heater plates 242 and an electrode (not shown) are provided. In each of the heater plates 242, substrate holding rollers 290 as described earlier are attached with a predetermined spacing along the lines corresponding to the upper and lower sides of the substrate W.

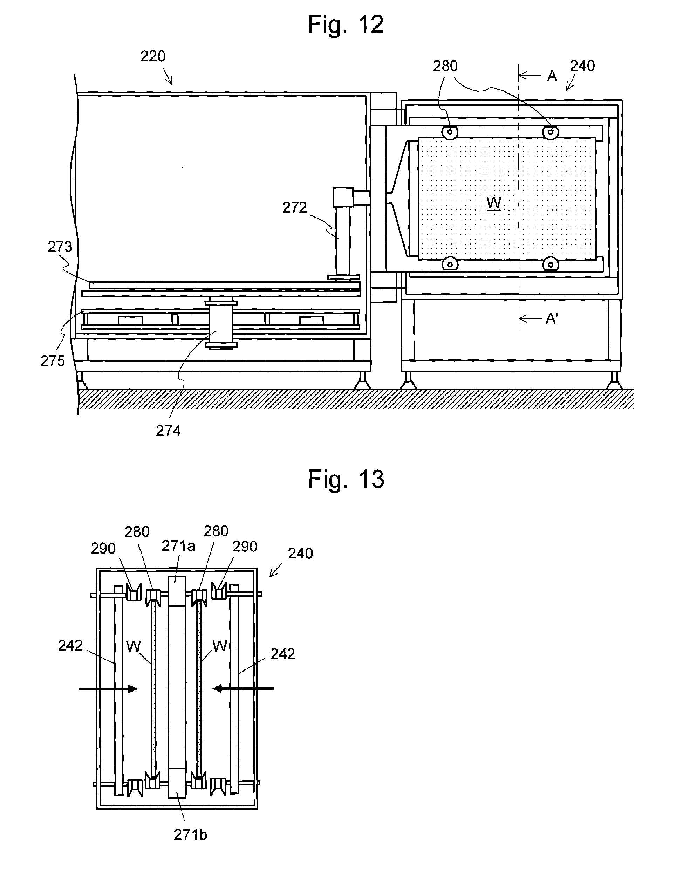

A substrate W mounted on the vacuum-side substrate carrying mechanism 270 is carried from the common carrying delivery chamber 220 to each processing chamber 240 in the following manner. First, the gate valve 241 provided between the common carrying delivery chamber 220 and the processing chamber 240 into which the substrate W will be carried is opened. Then the sliding base 273 is driven to make the carrying arms 271a and 271b enter the chamber 240 (Fig. 12). Fig. 13 illustrates the inside of the processing chamber 240 at this point in time and is a sectional view at line A-A' of Fig. 12. The carrying arms 271a and 271b are inserted in the space between the two heater plates 242. Each of the heater plates 242 can be moved toward the center of the processing chamber 240 (i.e. in the direction of the arrows in the figure) by a driving mechanism which is not shown. When the substrates W on the carrying arms 271a and 272b have arrived at the front of the heater plates 242, each heater plate 242 is moved closer to the substrates W. Then, the substrate holding rollers 290 on the heater plates 242 are set to be in the substrate holding state and the substrate holding rollers 280 on the carrying arms 271a and 271b are set to be in the holding release state. Thereby, each substrate W is delivered from the carrying arms 271a and 271b to the heater plates 242.

After the substrates W have been delivered/received by the aforementioned process, the sliding base 273 is driven so that the carrying arms 271a and 271b exit from the processing chamber 240 to the common carrying delivery chamber 220. After the gate valve 241 is closed, a predetermined thin film is formed on each of the substrates W in the processing chamber 240.

After that, when the processing of the substrates W has been finished in the processing chamber 240, the previously described carrying-in procedure is followed in the reverse order: each of the glass substrates W are delivered to the carrying arms 271a and 271b from each heater plate 242, and carried out into the common carrying delivery chamber 220. If the substrates W are to be further processed in other processing chamber 240, the traveling base 275 is made to run on the rail laid in the common carrying delivery chamber 220 to move the carrying arms 271a and 271b to the front of the subsequent processing chamber 240, and the substrates W are carried in and out as in the manner described above.

A predetermined substrate holding mechanism including substrate holding rollers as those described above is provided in each of the load lock chambers 210 and 260, the preheating chamber 230, and the cooling chamber 250, other than the processing chambers 240. A substrate W is delivered and received according to the procedure as previously described between the atmosphere-side substrate carrying mechanism and the substrate holding mechanism in each of the load lock chambers 210 and 260, and between the vacuum-side substrate carrying mechanism 270 and the substrate holding mechanism in the load lock chambers 210 and 260, preheating chamber 230, and cooling chamber 250.

As previously described, with the substrate processing apparatus according to the present embodiment, a substrate is held or released from the holding state with the substrate holding rollers, and therefore a substrate can be stably held and assuredly delivered/received. In addition, since two substrates can be simultaneously delivered/received in the load section and subsequently carried and processed, the throughput are increased. Further, the configuration that substrates are carried vertically to the ground brings about effects that the installation area of the entire substrate processing apparatus can be reduced compared to the apparatus in which substrates are carried in an oblique position, and a contamination by particles falling onto the substrates or other reasons can be prevented.

## Claims

1. A substrate holding mechanism including a substrate holding unit for holding a rectangular substrate, comprising:
a) a plurality of substrate holding rollers provided at positions corresponding to two opposite sides of the substrate on the substrate holding unit and rotatably supported by the substrate holding unit; and
b) a roller driver for rotating the substrate holding rollers, wherein:
the substrate holding roller includes a cylinder part and a holding flange provided along a portion of a circumference of each end of the cylinder part; and
each of the substrate holding rollers is rotated by the roller driver so that the holding flange can be switched between a state of holding edges of the substrate and a state of releasing the substrate in accordance with a rotation angle of the substrate holding rollers.

2. A substrate delivering/receiving mechanism including a first substrate holding means and a second substrate holding means, each including the substrate holding mechanism according to claim 1, wherein:
the substrate holding rollers of the first substrate holding means and the substrate holding rollers of the second substrate holding means are placed at a position where the substrate holding rollers are free from obstructing each other when the substrate holding units of both substrate holding means are made to face each other; and
the first substrate holding means holding a substrate and the second substrate holding means without a substrate are moved closer to each other with the substrate holding units of both substrate holding means opposing each other, then the substrate holding rollers on the second substrate holding means are rotated to hold the edges of the substrate by each of the holding flanges and the substrate holding rollers on the first substrate holding means are rotated to release the edges of the substrate by each of the holding flanges, so that the substrate is delivered from the first substrate holding means to the second substrate holding means.

3. The substrate delivering/receiving mechanism according to claim 2, wherein:
the first substrate holding means is a substrate standing mechanism for holding a substrate carried in a horizontal position and for standing the substrate to a vertical position;
the second substrate holding means is a both-side type substrate holding means including the substrate holding unit on each of a front side and a back side; and
two substrates are first set from a horizontal position to a vertical position by the two first substrate holding means placed to sandwich the second substrate holding means, and the substrates are delivered to each of the substrate holding units of the second substrate holding means.

4. A substrate processing apparatus including the substrate holding mechanism according to claim 1.
